# EUROPÄISCHE PATENTSCHRIFT

(11) **EP 2 936 234 B1**
(45) Veröffentlichungstag und Bekanntmachung des Hinweises auf die Patenterteilung: **27.11.2019**
(21) Anmeldenummer: 13814828.3
(22) Anmeldetag: 13.12.2013
(51) Int. Cl.: G02B 27/00

(54) **VERFAHREN ZUR HERSTELLUNG EINER WELLENFRONTKORRIGIERTEN OPTISCHEN ANORDNUNG AUS MINDESTENS ZWEI OPTISCHEN ELEMENTEN**
METHOD FOR PRODUCING A WAVEFRONT-CORRECTED OPTICAL ARRANGEMENT COMPRISING AT LEAST TWO OPTICAL ELEMENTS
PROCÉDÉ DE CONSTRUCTION D'UN SYSTÈME OPTIQUE À FRONT D'ONDE CORRIGÉ, COMPOSÉ D'AU MOINS DEUX ÉLÉMENTS OPTIQUES

(30) Priorität: 20.12.2012 DE 102012112773
(43) Veröffentlichungstag der Anmeldung: 28.10.2015
(73) Patentinhaber: JENOPTIK Optical Systems GmbH, 07745 Jena (DE)
(72) Erfinder: WERSCHNIK, Jan, 07743 Jena (DE); AUGUSTIN, Markus, 07743 Jena (DE)
(74) Vertreter: Waldauf, Alexander
(86) Internationale Anmeldenummer: PCT/EP2013/003773
(87) Internationale Veröffentlichungsnummer: WO 2014/095013

(56) Entgegenhaltungen:
- WO-A1-2005/121899
- DE-A1- 10 258 715
- DE-A1-102005 022 459

## Beschreibung

Bei der Herstellung von optischen Anordnungen, insbesondere von optischen Hochleistungssystemen, werden sehr hohe Anforderungen an die Toleranzen der gesamten optischen Anordnung und der daraus resultierenden zulässigen Toleranzen der Einzelkomponenten gestellt.

Abweichungen der Einzelkomponenten von einer theoretisch idealen Form und einem idealen optischen Verhalten äußern sich üblicherweise in einem Wellenfrontfehler der Strahlenbündel, welche die optische Anordnung passieren. Als Wellenfrontfehler werden zwei- oder dreidimensionale Abweichungen der Wellenfronten (Flächen gleicher Phase) von einer idealen Wellenfront verstanden, wie z. B. einer idealen ebenen Wellenfront (Planwelle) oder einer idealen sphärischen Wellenfront (Kugelwelle).

Die Anfertigung und Verwendung von Einzelkomponenten mit engen Toleranzgrenzen ist fertigungstechnisch aufwendig, verursacht viele Ausschussteile, erfordert einen hohen Messaufwand und ist daher teuer und schwer in eine Produktion größerer Stückzahlen zu überführen.

Eine Möglichkeit, den Herstellungsaufwand der Einzelkomponenten zu minimieren besteht darin, dass zur Kompensation einer Wellenfrontdeformation (= Wellenfrontfehler) mindestens zwei vorgefertigte optische Kompensationselemente in den Strahlengang einer optischen Anordnung eingefügt werden, wie dies beispielsweise aus der EP 0 823 976 B1 bekannt ist. Dazu wird der Wellenfrontfehler an der optischen Anordnung mittels eines Wellenfrontmessinstruments gemessen. Entsprechend dem Ergebnis der Messung werden die optischen Kompensationselemente ausgewählt. Der Nachteil dieser Lösung besteht in der notwendigen Vorhaltung einer Anzahl von optischen Kompensationselementen, dem Bedarf weiterer Elemente in der optischen Anordnung sowie dem hohen Montageaufwand und Platzbedarf für die optischen Kompensationselemente.

Eine andere Herangehensweise ist aus der DE 102 58 715 B4 bekannt. In dem dort offenbarten Verfahren zur Herstellung einer optischen Anordnung in Form eines optischen Abbildungssystems mit einer Vielzahl von optischen Elementen wird zuerst die optische Anordnung zusammengebaut. Dabei werden die optischen Elemente lagerichtig angeordnet. Anschließend wird die zusammengebaute optische Anordnung vermessen und ortsaufgelöst ein Wellenfrontfehler in der Austrittspupille oder in einer dazu konjugierten Fläche der optischen Anordnung ermittelt. In einem nächsten Schritt wird mindestens eine als Korrekturasphäre vorgesehene Korrekturfläche an mindestens einem der optischen Elemente ausgewählt und eine Topographie und/oder eine Brechzahlverteilung der Korrekturfläche berechnet, durch die eine Korrektur des ermittelten Wellenfrontfehlers der optischen Anordnung bewirkt werden kann. Um die erforderlichen Veränderungen entsprechend der berechneten Topographie und/oder der Brechzahlverteilung der Korrekturfläche herstellen zu können, wird die mindestens eine Korrekturasphäre aus der optischen Anordnung ausgebaut und ortsaufgelöst bearbeitet. Dabei ist es wichtig, die Korrekturasphäre nach einer erfolgten Bearbeitung koordinatenrichtig, d. h. in der bei der Berechnung der Korrekturwerte (Topographie und/oder Brechzahlverteilung) verwendeten Ausrichtung und Drehlage wieder in die optische Anordnung einzubauen, um den erwünschten Effekt der Korrektur des Wellenfrontfehlers zu erreichen. Das kompensierende Element korrigiert die Summe der Fehler der einzelnen optischen Elemente.

Nachteilig an dieser Vorgehensweise ist, dass die optische Anordnung erst tatsächlich zusammengebaut, dann wieder teilweise demontiert und anschließend wieder endmontiert, und gegebenenfalls erneut justiert, werden muss. Dadurch sind zusätzliche Arbeitsschritte vonnöten, um die optische Anordnung herzustellen.

Durch eine Lösung gemäß der DE 10 2005 022 459 A1 ist ein Verfahren zur Optimierung der Güte eines optischen Systems bekannt, das aus mindestens zwei Elementen mit optisch wirksamen Oberflächen (optische Elemente) besteht. Von den einzelnen optischen Elementen oder von Gruppen optischer Elemente wird ein verursachter spezifischer Wellenfrontfehler ermittelt, indem Abweichungen einer Ist-Form der Oberflächenformen von einer Soll-Form bestimmt werden und anschließend rechnerisch der betreffende spezifische Wellenfrontfehler berechnet wird. Die einzige offenbarte Berechnungsvorschrift ist dabei jedoch nicht zur feldabhängigen Simulation der spezifischen Wellenfrontfehler geeignet. Aufgrund der Berechnungsergebnisse wird rechnerisch der zu erwartende Gesamtwellenfrontfehler des optischen Systems vorausbestimmt und es wird ermittelt, durch welche Oberflächenformen der Gesamtwellenfrontfehler korrigiert werden kann, wobei die ermittelten spezifischen Wellenfrontfehler zugrunde gelegt werden. Auf mindestens einer Oberfläche werden diese ermittelten Oberflächenformen ausgebildet und erst dann tatsächlich das optische System zusammengesetzt. Gemäß der Vorgehensweise der DE 10 2005 022 459 A1 werden die Wellenfrontfehler feldunabhängig korrigiert. Dieser Ansatz ist bei feldabhängigen optischen Systemen (z. B. Projektionsobjektiven) nicht zielführend, da der Wellenfrontfehler eines Feldpunktes eine individuelle (= feldpunktabhängige) Korrektur benötigt. Nach der DE 10 2005 022 459 A1 wird jeder Wellenfrontfehler um die gleiche Wellenfront (Phasenfunktion) korrigiert, wodurch das Korrekturpotential nicht ausgeschöpft wird.

WO 2005/121 899 A1 beschreibt ein Verfahren zur Herstellung einer Wellenfrontkorrigierten optischen Anordnung gemäß dem Stand der Technik.

Der Erfindung liegt die Aufgabe zugrunde, ein Verfahren vorzuschlagen, mittels dem eine effiziente Herstellung einer wellenfrontkorrigierten optischen Anordnung ermöglicht ist.

Die Lösung der Aufgabe erfolgt in einem Verfahren zur Herstellung einer wellenfrontkorrigierten optischen Anordnung aus mindestens zwei optischen Elementen, bei dem in einem Schritt a) ein Gesamtwellenfrontfehler der optischen Anordnung ermittelt wird; in einem Schritt b) der Gesamtwellenfrontfehler mit einem zulässigen Toleranzbereich des Gesamtwellenfrontfehlers verglichen wird; in einem Schritt c) bei einer Überschreitung des zulässigen Toleranzbereiches mindestens eines der optischen Elemente ausgewählt wird und in einem Schritt d) die optischen Eigenschaften des mindestens einen ausgewählten optischen Elements derart verändert werden, dass der ermittelte Gesamtwellenfrontfehler der optischen Anordnung innerhalb des zulässigen Toleranzbereiches zu liegen kommt. Gekennzeichnet ist das erfindungsgemäße Verfahren dadurch, dass in einem vor dem Schritt a) durchzuführenden Schritt a-2) die optischen Elemente individualisiert werden, indem diesen jeweils eine individuelle Kennung zugeordnet wird. Die individuelle Kennung kann beispielsweise eine Kennziffer, eine Kombination aus Buchstaben, Ziffern und Zeichen oder ein Barcode auf einer Fassung des optischen Elements sein. Die Kennung kann auch auf einer Fläche, beispielsweise einer Umfangsfläche des optischen Elements, vorhanden sein. Als eine individuelle Kennung kann auch eine eineindeutige Ablageposition des jeweiligen optischen Elements z. B. in einem Lager verwendet werden, ohne dass auf dem optischen Element physisch eine Kennung vorhanden ist. Von allen individualisierten optischen Elementen werden individuelle Oberflächenfehler koordinatenrichtig gemessen und die gemessenen individuellen Oberflächenfehler koordinatenrichtig dem jeweiligen individualisierten optischen Element zugeordnet gespeichert. Günstig ist dabei, wenn jedes optische Element eine Markierung erhält, von der sich eine bestimmte Drehlage des optischen Elements ableiten lässt. In weiteren Ausführungen der Erfindung kann die Kennung als Markierung verwendet werden, die Markierung kann ein Teil der Kennung sein oder die Markierung kann in die Kennung integriert sein. In einem ebenfalls vor dem Schritt a) auszuführenden Schritt a-1) wird die optische Anordnung mit den individualisierten optischen Elemente virtuell hergestellt, so dass eine virtuelle optische Anordnung entsteht. In dem Schritt a) erfolgt das Ermitteln des Gesamtwellenfrontfehlers der virtuellen optischen Anordnung durch Berechnung aus den individuellen Oberflächenfehlern und über alle Feldpunkte. Dadurch wird ein berechneter Gesamtwellenfrontfehler erhalten, wobei der Gesamtwellenfrontfehler die Gesamtheit von Wellenfrontfehlern über alle Feldpunkte ist, sodass eine Korrektur des Gesamtwellenfrontfehlers gleichzeitig für alle Feldpunkte ermöglicht ist.
In dem Schritt b) wird der berechnete Gesamtwellenfrontfehler mit dem zulässigen Toleranzbereich des Gesamtwellenfrontfehlers verglichen. Die optischen Eigenschaften des mindestens einen ausgewählten individualisierten optischen Elements werden in dem Schritt d) virtuell so verändert, dass der berechnete Gesamtwellenfrontfehler der optischen Anordnung innerhalb des zulässigen Toleranzbereiches zu liegen kommt. Die virtuell vorgenommenen Veränderungen der optischen Eigenschaften des mindestens einen ausgewählten individualisierten optischen Elements werden in einem Schritt e) als Bearbeitungsdaten gespeichert und wiederholt abrufbar bereitgestellt. Schlussendlich wird in einem Schritt f) das mindestens eine ausgewählte individualisierte optische Element entsprechend der Bearbeitungsdaten bearbeitet und die optische Anordnung wird mit den individualisierten optischen Elementen hergestellt. Nach dem Schritt f) ist die optische Anordnung hergestellt und tatsächlich physisch vorhanden.

Wellenfrontfehler sind Abweichungen einer tatsächlichen Wellenfront von einer idealen Wellenfront (z. B. Kugel - oder ebene Welle). Aus den Wellenfrontfehlern ergeben sich beispielsweise Seidel-Fehler, Bildfeldwölbungen, Punktbilder und Verzeichnungen. Letztere können als eine Verkippung der Wellenfront beschrieben werden.

Unter einem Gesamtwellenfrontfehler wird die Gesamtheit von Wellenfrontfehlern über alle Feldpunkte verstanden. Der Vorteil des erfindungsgemäßen Verfahrens liegt darin, dass eine feldabhängige Simulation ermöglicht ist und eine Optimierung des Gesamtwellenfrontfehlers gleichzeitig für alle Feldpunkte durchgeführt werden kann. Feldpunkte im Sinne der Beschreibung können auch Objektpunkte sein. Dabei wird der Gesamtwellenfrontfehler derart optimiert, dass dieser innerhalb des zulässigen Toleranzbereichs liegt.

Als Feld (verkürzend von Sehfeld, engl.: field of view) wird hier die Gesamtheit aller Feldpunkte verstanden.

Unter einem Feldpunkt versteht man den Startpunkt oder den Startwinkel eines Strahlenbündels. Feldpunkte sind Positionen in dem Feld, die sich durch Koordinaten angeben lassen. Ein Gesamtstrahlenbündel setzt sich dabei aus allen Strahlenbündeln zusammen.

Der Begriff der feldabhängigen Simulation bedeutet, dass die Wellenfrontfehlerbeiträge einer jeden Oberfläche in Abhängigkeit des Feldpunktes berechnet (simuliert) werden. Im Allgemeinen gibt es in einem optischen System Linsen, bei denen die Strahlenbündel verschiedener Feldpunkte sehr unterschiedliche Volumina (insbesondere dann Teile der Oberfläche) durchdringen (sogenannte feldnahe Linsen). Bei anderen, als pupillennah bezeichneten Linsen oder optischen wirksamen Flächen werden nahezu gleiche Volumina mit Strahlenbündeln aus verschiedenen Feldpunkten durchsetzt. Die unterschiedlich durchsetzten Volumina müssen in der Simulation berücksichtigt werden. Feldnahe Linsen eigenen sich daher besonders zur Korrektur feldabhängiger Wellenfrontfehler.

Der Begriff der Korrektur wird in dieser Beschreibung in Bezug auf das erfindungsgemäße Verfahren dahingehend verstanden, dass eine Optimierung des Gesamtwellenfrontfehlers hinsichtlich einer Zielgröße (zulässiger Toleranzbereich) erfolgt. Liegt der Gesamtwellenfrontfehler über oder unter der Zielgröße, ist eine adäquate Korrektur erforderlich, um den Gesamtwellenfrontfehler wieder mit der Zielgröße in Übereinstimmung zu bringen. Durch eine sorgfältige Durchführung der Korrektur wird die Optimierung des Gesamtwellenfrontfehlers erreicht.

Optische Elemente sind über ihre Ausdehnung nicht ideal, sondern zeigen geringe material- und fertigungstechnisch bedingte Abweichungen (Oberflächenfehler, Irregularitäten). Dabei tragen z. B. einzelne Bereiche der Oberfläche des optischen Elements jeweils individuell zu einem Wellenfrontfehler bei, der durch das optische Element verursacht wird. Diese individuellen Oberflächenfehler können beispielsweise taktil, interferometrisch oder mittels Streifenprojektion gemessen werden.

Wesentlich für die Erfindung ist die Erkenntnis, dass der Gesamtwellenfrontfehler nur unwesentlich durch die Fassungen, die Materialhomogenität und die Beschichtungen der einzelnen individualisierten optischen Elemente hervorgerufen wird. Der bedeutendste Betrag zum Gesamtwellenfrontfehler der optischen Anordnung wird durch Irregularitäten auf der Oberfläche bewirkt. Es ist daher möglich, lediglich auf der Basis von koordinatenrichtigen Messdaten der individualisierten optischen Elemente einen Gesamtwellenfrontfehler einer optischen Anordnung zu berechnen. Koordinatenrichtig bedeutet, dass die Beiträge zu den individuellen Wellenfrontfehlern den entsprechenden Bereichen des betrachteten optischen Elements zugeordnet werden und bei Kenntnis der jeweiligen Drehlage des optischen Elements die räumliche Anordnung der Bereiche und der durch diese verursachten Wellenfrontfehler bekannt sind. Eine Drehlage kann z. B. gegenüber einem festen Bezugspunkt und / oder einer Bezugsebene definiert werden (z. B. ein festes Koordinatensystem in einem Labor oder einer Produktionsstätte).

In einer ersten Ausgestaltung des erfindungsgemäßen Verfahrens werden nur diejenigen individualisierten optischen Elemente berücksichtigt, durch die eine Einhaltung zulässiger Toleranzgrenzen der individuellen Wellenfrontfehler erreicht ist. In einer weiteren Ausgestaltung des erfindungsgemäßen Verfahrens werden auch individualisierte optische Elemente verwendet, durch die zulässige Toleranzgrenzen nicht eingehalten sind. Die Möglichkeit der Verwendung von ansonsten auszusondernden oder nachzubearbeitenden individualisierten optischen Elementen ist durch das erfindungsgemäße Verfahren vorteilhaft ermöglicht, da eine Optimierung des Gesamtwellenfrontfehlers erfolgt.

Der Begriff des Gesamtwellenfrontfehlers steht für eine bei der Durchführung des erfindungsgemäßen Verfahrens zu messenden Zielgröße. Diese kann z. B. nach Zerlegung des Gesamtwellenfrontfehlers in Zernike-Koeffizienten auch durch Einzelzernike-Koeffizienten gegeben sein. Die Zielgröße kann zur gezielten Beeinflussung des Gesamtwellenfrontfehlers verändert werden.

Es ist eine sehr günstige Ausführung des erfindungsgemäßen Verfahrens, wenn in Schritt a) eine Anzahl von virtuellen Strahlenbündeln (= Teilstrahlenbündel eines Gesamtstrahlenbündels) erzeugt und deren Verhalten bei einem Durchgang durch die virtuelle optische Anordnung berechnet wird. Der Startpunkt der virtuellen Strahlenbündel ist die Objektebene. In Schritt a) wird eine beliebige Anzahl von Feldpunkten betrachtet und für jeden Feldpunkt wird ein virtuelles Strahlenbündel erzeugt. Die Projektion jedes virtuellen Strahlenbündels auf jede Oberfläche jedes individualisierten optischen Elements (Subapertur) beim Durchgang durch die virtuelle optische Anordnung wird berechnet.

Durch eine Projektion eines virtuellen Strahlenbündels ausgehend von einem Feldpunkt auf jeder Oberfläche eines jeden individualisierten optischen Elements ist eine Fläche überdeckt, die je nach Position des individualisierten optischen Elements im Strahlengang der optischen Anordnung und der damit einhergehenden Divergenz, Konvergenz oder Parallelität der Strahlen des jeweiligen virtuellen Strahlenbündels an dieser Position, eine bestimmte Größe, Form und Lage relativ zur optischen Anordnung aufweist. Für jeden Feldpunkt wird diese bestimmte Größe, Form und Lage relativ zur optischen Anordnung ermittelt und jeweils als eine sogenannte Subapertur gespeichert. Jeder Feldpunkt hinterlässt also, vermittelt durch das virtuelle Strahlenbündel, einen individuellen "Fußabdruck" (Bereich) auf der Oberfläche des individualisierten optischen Elements. Irregularitäten auf der Oberfläche der individualisierten optischen Elemente innerhalb eines solchen Bereichs (=Subapertur) können beispielsweise über die Brechzahl des individualisierten optischen Elements in einen individuellen Wellenfrontfehler umgerechnet und gespeichert werden. Jeder individuelle Wellenfrontfehler stellt einen Beitrag zum berechneten Gesamtwellenfrontfehler dar.

Eine jede Oberfläche und eine jede Subapertur kann in verschiedenen, dem Fachmann bekannten, Weisen unter Verwendung eines Bezugssystems beschrieben werden. So kann ein Bezugssystem beispielsweise eine Bezugsebene oder ein geeignetes Koordinatensystem festgelegt sein, bezüglich dem die Oberfläche oder die Subapertur eindeutig beschrieben werden kann. Koordinatensysteme können z. B. zwei oder dreidimensionale kartesische Koordinatensysteme oder Polarkoordinatensysteme sein. Die Beschreibung der Oberfläche und / oder der Subapertur kann auch durch Funktionensysteme erfolgen. Beispielsweise kann durch eine Zernike-Darstellung unter Nutzung der Zernike-Polynome eine Irregularität oder ein individueller Wellenfrontfehler beschrieben werden. Zugleich haben die Koeffizienten eine anwendungsnahe Bedeutung. Sie ermöglichen eine bessere Beurteilung der Wirkung der einzelnen Oberflächen bzw. der Subaperturen auf die gesamte optische Anordnung. Eine Auswahl eines Bezugssystems kann in Abhängigkeit von der Gestaltung eines jeweiligen (individualisierten) optischen Elements erfolgen. Eine Beschreibung der Oberfläche erfolgt koordinaten- und lagerichtig.

Von jeder Subapertur kann ein Beitrag zum berechneten Gesamtwellenfrontfehler abgeleitet werden. Der berechnete Gesamtwellenfrontfehler ist daher als ein resultierender Fehler aus der Anzahl der Beiträge der Subaperturen verstanden und darstellbar. Der berechnete Gesamtwellenfrontfehler kann daher ermittelt werden, indem die abgeleiteten Beiträge vorzeichenrichtig und orientierungsrichtig addiert werden. In einer weiteren Ausführung des erfindungsgemäßen Verfahrens werden die abgeleiteten Beiträge zum berechneten Gesamtwellenfrontfehler in Koeffizienten zerlegt und anschließend die Koeffizienten vorzeichenrichtig und orientierungsrichtig addiert.

Die virtuellen Strahlenbündel können in einem beliebigen Raster mit vorzugsweise bekannten Rasterabständen zueinander angeordnet werden. Dabei sind die Rasterabstände vorzugsweise zwar bekannt, diese müssen aber nicht gleich sein. Das Raster kann daher regelmäßig, unregelmäßig oder eine Kombination von regelmäßigen und unregelmäßigen Rasterabständen sein. Das Raster kann durch eine Matrix von Feldpunkten gegeben sein. Beispielsweise kann es sinnvoll sein, die Rasterabstände fern der optischen Achse geringer zu wählen als die Rasterabstände nahe der optischen Achse. Dadurch wird vorteilhaft eine hinreichende Abdeckung der Randbereiche der individualisierten optischen Elemente durch die virtuellen Strahlenbündel erreicht.

Von besonderer Bedeutung dabei ist, dass die Rasterabstände so gewählt werden, dass sich die Subaperturen auf einer Oberfläche des ausgewählten individualisierten optischen Elements mindestens teilweise überlagern. Der Grad der Überlagerung kann z. B. als ein Verhältnis der Querschnittsflächen der virtuellen Strahlenbündel an der Position der Oberfläche des individualisierten optischen Elements zur Fläche, auf die virtuelle Strahlen mindestens zweier virtueller Strahlenbündel auftreffen, in Prozent angegeben werden. Eine vollständige Überlagerung bietet den Vorteil, dass die zu berechnende Korrekturfläche des ausgewählten individualisierten optischen Elements an keiner Stelle interpoliert werden muss und somit Berechnungsartefakte vermieden werden, die unter Umständen zur Verletzung des Gesamtwellenfrontfehlers zwischen den Rasterpunkten führen würden.

Es ist ferner möglich, Durchbiegungen und andere Deformationen der individualisierten optischen Elemente zu berücksichtigen, wie diese beispielsweise beim Fassen der individualisierten optischen Elemente auftreten können. Durch eine solche Berücksichtigung wird die Übereinstimmung der Berechnung mittels des erfindungsgemäßen Verfahrens mit einem tatsächlichen Gesamtwellenfrontfehler verbessert.

Ferner ist es in einer Weiterentwicklung des erfindungsgemäßen Verfahrens möglich, aus einer Anzahl von individualisierten optischen Elementen eine Auswahl zu treffen und solche individualisierten optischen Elemente in einer jeweiligen optischen Anordnung zu kombinieren, bei deren Verwendung und Kombination erforderliche Veränderungen prozess- und fertigungstechnisch effizient zu gestalten sind. Anhand von Messdaten können aus einer Anzahl von individualisierten optischen Elementen Kombinationen der individualisierten optischen Elemente ausgewählt werden. Die Auswahl der Kombinationen erfolgt so, dass die für eine Kombination berechneten Bearbeitungsdaten fertigungstechnisch optimiert sind. So können beispielsweise größere Lose der optischen Elemente hergestellt, vermessen und individualisiert werden. Aus diesen Losen ist eine optimierte Auswahl der individualisierten optischen Elemente möglich, durch die möglichst viele optische Anordnungen bei geringstem Aufwand für Veränderungen der individualisierten optischen Elemente herstellbar sind.

In einer weiterführenden Ausgestaltung des erfindungsgemäßen Verfahrens wird eine virtuelle Veränderung der Drehlage ("clocking") mindestens eines individualisierten optischen Elements durchgeführt. Dadurch können erforderliche Veränderungen dann reduziert oder ganz vermieden werden, wenn durch eine Veränderung der Drehlage vorteilhaft kompensatorische Effekte nutzbar sind. Diese Vorgehensweise ist mit der vorstehend beschriebenen Auswahl individualisierter optischer Elemente kombinierbar.

Mit dem erfindungsgemäßen Verfahren ist es zusätzlich möglich, eine Verzeichnung in der Bildebene auf einem feldnahen individualisierten optischen Element zu korrigieren. Die Verzeichnung wird dabei aus der lokalen Neigung des feldpunktabhängigen Wellenfrontfehlers berechnet. Außerdem kann auch die Bildfeldwölbung aus dem Gesamtwellenfrontfehler an allen Feldpunkten berechet werden, z. B. als feldpunktabhängiger Defokus-Koeffizient bei Zerlegung des Gesamtwellenfrontfehlers in Zernike-Polynome.

Auch durch ideale optische Anordnungen kann ein Beitrag zum Gesamtwellenfrontfehler bewirkt sein. Dieser als Nominalfehler bezeichnete Beitrag kann für jeden Feldpunkt berücksichtigt werden und bei der Berechnung in Schritt d) mit eingehen.

In einer Ausführung des erfindungsgemäßen Verfahrens können die individualisierten optischen Elemente Weißteile sein. Weißteile sind individualisierte optische Elemente, die noch nicht beschichtet, z. B. mit einer Antireflexschicht, versehen worden sind. Die Weißteile können gefasst sein. Es ist allgemein bekannt, dass durch eine Fassung Spannungen und Verformungen eines optischen Elements verursacht sein können, was zusätzlich zu individuellen Wellenfrontfehlern führen kann. Durch eine Fassung verursachte individuelle optische Eigenschaften können in Schritt a-2) separat und/oder als Beitrag zu den individuellen optischen Eigenschaften des jeweiligen individualisierten optischen Elements gemessen und gespeichert werden.

In einer weiterführenden Ausgestaltung des erfindungsgemäßen Verfahrens ist das mindestens eine ausgewählte individualisierte optische Element ein Weißteil.

Ist mindestens ein individualisiertes optisches Element ein Weißteil, so werden in dem Schritt f) vor der eigentlichen Herstellung der optischen Anordnung alle Weißteile in einen Endzustand überführt. Darunter sind alle Fertigungsschritte und -vorgänge zu verstehen, durch die ein Weißteil in ein voll funktionsfähiges individualisiertes optisches Element überführt wird. Insbesondere ist dies das Aufbringen von ein- oder mehrlagigen Beschichtungen auf und / oder das Anbringen einer Fassung an dem individualisierten optischen Element.

Eine Korrektur des Gesamtwellenfrontfehlers an einer optischen Anordnung mit Weißteilen erlaubt eine sehr flexible Auswahl der individualisierten optischen Elemente bzw. der zu verändernden Oberflächen bzw. Subaperturen. Das ist besonders dann günstig, wenn ein dominierender Beitrag zum Gesamtwellenfrontfehler von sogenannten Weißteilfehlern herrührt. Die Weißteilfehler sind beispielsweise durch Irregularitäten auf den Oberflächen der Weißteile verursacht. Bei der Durchführung des erfindungsgemäßen Verfahrens kann jedes individualisierte optische Element und beliebig viele individualisierte optische Elemente ausgewählt werden. Dadurch lassen sich die für die Weißteile geltenden zulässigen Toleranzgrenzen vergrößern und somit Kosten sparen und Durchlaufzeiten durch die Fertigungskette reduzieren.

Geschieht die Korrektur des Gesamtwellenfrontfehlers weitgehend auf der Basis bereits beschichteter und gefasster individualisierter optischer Elemente, sind die ausgewählten individualisierten optischen Elemente vorzugsweise bereits vorher festzulegen. Diese bleiben vorerst unbeschichtet und können in besonderen Fassungen gefasst sein. Dies schränkt die Flexibilität des erfindungsgemäßen Verfahrens etwas ein. Allerdings können Fehler, die durch das Fassen oder Beschichten entstehen, kompensiert werden.

Bei der Durchführung des erfindungsgemäßen Verfahrens kann die Anzahl der in Schritt **c)** ausgewählten individualisierten optischen Elemente in Abhängigkeit von dem virtuell ermittelten Gesamtwellenfrontfehler bestimmt werden. So kann eine Auswahl unter dem Kriterium erfolgen, dass möglichst wenige individualisierte optische Elemente ausgewählt werden müssen oder dass die je ausgewähltem individualisierten optischen Element erforderlichen Veränderungen so gering wie möglich gehalten werden. Es kann auch eine Unter- und / oder eine Obergrenze der Anzahl von ausgewählten individualisierten optischen Elementen festgelegt werden. Bei einer Auswahl einer größeren Anzahl individualisierter optischer Elemente können die individuellen Toleranzen der ausgewählten individualisierten optischen Elemente größer gewählt werden, sodass der Fertigungsaufwand je individualisiertem optischen Element sinkt. Wird nur ein einziges individualisiertes optisches Element ausgewählt, so müssen bei dessen Bearbeitung wesentlich engere Toleranzgrenzen eingehalten werden. Es ist in einer weiteren Ausgestaltung auch möglich, dass das individualisierte optische Element mit dem größten Beitrag zum Gesamtwellenfrontfehler ausgewählt wird und dessen optische Eigenschaften verändert werden, um den Gesamtwellenfrontfehler innerhalb der zulässigen Toleranz zu halten.

Durch eine Wahl der Anzahl ausgewählter individualisierter optischer Elemente ist eine flexible Verfahrensführung ermöglicht. Günstig, aber nicht zwingend, ist es, wenn die ausgewählten individualisierten optischen Elemente Weißteile sind. Durch eine Anpassung der Anzahl ausgewählter individualisierter optischer Elemente kann eine einzuhaltende Toleranz groß gewählt werden, wodurch Fertigungskosten eingespart werden. Ein Weißteil ist ein optisches Element, das (noch) nicht beschichtet ist. Weißteile sind Bearbeitungszustände optischer Elemente, die noch nicht vollständig fertiggestellt wurden.

Eine Veränderung der optischen Eigenschaften des mindestens einen ausgewählten individualisierten optischen Elements erfolgt virtuell, indem mindestens eine Oberfläche des ausgewählten individualisierten optischen Elements als eine Korrekturfläche behandelt wird. Die Korrekturfläche kann durch zwei - oder dreidimensionale Koordinaten beschrieben sein. Den Koordinaten können weitere Merkmale zugeordnet sein, sodass eine multidimensionale Beschreibung der Korrekturfläche möglich ist. Die Korrekturfläche kann auch in Form eines Funktionensystems wie z. B. mittels Zernike-, oder Hankel-Funktionen, B-Splines oder NURBS ("Non-uniform rational B-splines") erfolgen. Es ist auch möglich, den Brechungsindex lokal zu verändern oder diffraktive Strukturen auf die Oberfläche (Korrekturfläche) aufzubringen oder anzuarbeiten. Dabei wird die Korrekturfläche vor und nach einer Bearbeitung gemessen und mit einer berechneten Sollfläche verglichen. Entspricht die Korrekturfläche mit zulässigen Toleranzen der Sollfläche, kann die optische Anordnung hergestellt werden. Die Veränderungen der optischen Eigenschaften des mindestens einen ausgewählten individualisierten optischen Elements können auf einer oder auf beiden Seiten des ausgewählten individualisierten optischen Elements erfolgen.

Aufgrund der koordinatenrichtigen Abspeicherung der individuellen Wellenfrontfehler der individualisierten optischen Elemente können diese auch bezüglich ihrer Drehlage verändert und virtuell mit der veränderten Drehlage in der optischen Anordnung berechnet werden. Dadurch sind mögliche vorteilhafte Kompensationseffekte nutzbar, die durch eine veränderte Drehlage eines oder mehrerer individualisierter optischer Elemente zueinander erzielt werden.

Es ist möglich, dass in der optischen Anordnung ein individualisiertes optisches Element vorgesehen ist, welches an sich keinen Beitrag zum Gesamtwellenfrontfehler liefert, d. h. optisch neutral ist. Beispielsweise kann eine Planplatte in einem Bereich des Strahlengangs der optischen Anordnung mit paralleler Strahlführung vorgesehen sein. Mindestens eine Oberfläche der Planplatte ist als Korrekturfläche vorgesehen. Bei einer festgestellten erforderlichen Korrektur des Gesamtwellenfrontfehlers wird die Planplatte ausgewählt und deren optische Eigenschaften entsprechend verändert. Die Planplatte ist dann ein individualisiertes optisches Element der optischen Anordnung und optisch nicht neutral. Vorteilhaft daran ist, dass alle anderen individualisierten optischen Elemente bereits ihren jeweiligen Endzustand aufweisen können, beispielsweise abschließend beschichtet und gefasst sein können. Lediglich die optischen Eigenschaften des ausgewählten individualisierten optischen Elements werden verändert. Es ist auch möglich, dass das ausgewählte individualisierte optische Element dann nicht in die optische Anordnung verbaut wird, wenn ein berechneter Gesamtwellenfrontfehler innerhalb zulässiger Toleranzgrenzen liegt und keine Korrektur erforderlich ist.
Die Aufgabe wird ferner durch eine Abwandlung des erfindungsgemäßen Verfahrens gelöst. Dabei ist der Schritt f) nur optional vorgesehen. Mit dieser Abwandlung ist ein Korrekturverfahren vorgeschlagen, mittels dem rein virtuell eine wellenfrontkorrigierte optische Anordnung bereitgestellt werden kann.

Eine Bearbeitung in dem Schritt f) kann beispielsweise mittels einer lokalen Korrekturmethode (zonales Korrekturpolieren, IBF (Ion Beam Figuring), MRF (Magneto Rheological Finishing), FJP (Fluid Jet Polishing), CCP (Computer-Controlled Polishing), entsprechend der berechneten Korrektur erfolgen.

Vorzugweise wird das erfindungsgemäße Verfahren bei optischen Anordnungen zur Verwendung mit UV-Strahlung im Bereich der Halbleiterlithographie verwendet. Sie lässt sich aber auch in anderen Anwendungsbereichen nutzen und ist nicht auf abbildende optische Anordnungen beschränkt.

Durch das erfindungsgemäße Verfahren sind mehrere Vorteile erreicht. Zum einen wird der Aufbau von schwierig korrigierbaren optischen Anordnungen vermieden. Durch die realitätsnahe Berechnung sind optische Elemente allgemein und individualisierte optische Elemente im Speziellen identifizierbar. Werden beispielsweise durch das Fassen weitere Beiträge zum Gesamtwellenfrontfehler verursacht, sind diese zumeist von einfacher Art (z. B. Astigmatismus). Optimierungen des Gesamtwellenfrontfehlers der optischen Anordnung können frühzeitig im Fertigungsprozess erfolgen und für jede optische Anordnung individuell vorgenommen werden. Außerdem können Veränderungen an ausgewählten individualisierten optischen Elementen zeitgleich vorgenommen werden. Dadurch ist vorteilhaft eine Verkürzung der Durchlaufzeit durch den Fertigungsprozess erreicht. Gegenüber einer reinen Messung kann das berechnete Raster viel enger gewählt werden, wodurch Artefakte durch eine zu grobe Rasterung vermieden werden. Werden Messungen an sehr feinen Rasterungen vorgenommen, wird für diese Messungen viel (Mess-)Zeit benötigt. Das erfindungsgemäße Verfahren erlaubt auch größere Toleranzen der optischen Elemente, da diese korrigiert werden können. Dadurch ist vorteilhaft eine Ausschussquote bei der Herstellung optischer Elemente reduziert. In dem erfindungsgemäßen Verfahren sind Daten wie individuelle Kennungen und koordinatenrichtig gespeicherte Oberflächenfehler von optischen Elementen verwendbar, die in vielen Fällen entweder sowieso ermittelt und gespeichert werden bzw. die mit vergleichsweise geringem Aufwand erhoben werden können.

Die Erfindung wird nachfolgend anhand von Abbildungen und Ausführungsbeispielen näher erläutert. Es zeigen:
- Fig. 1: eine vereinfachte Darstellung eines individualisierten optischen Elements,
- Fig. 2: eine schematische Darstellung eines ersten Ausführungsbeispiels einer virtuellen optischen Anordnung mit individualisierten optischen Elementen,
- Fig. 3: eine Sequenz von schematisiert dargestellten Subaperturen der individualisierten optischen Elemente des ersten Ausführungsbeispiels und
- Fig. 4: eine schematische Darstellung eines zweiten Ausführungsbeispiels einer virtuellen optischen Anordnung mit individualisierten optischen Elementen mit einer Planplatte.

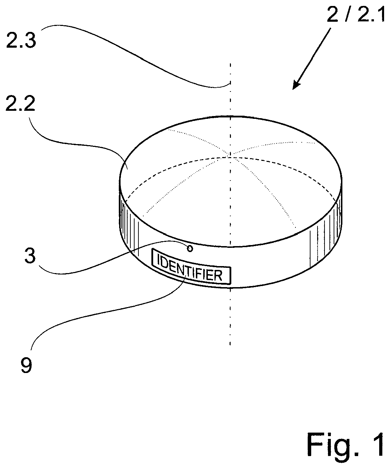

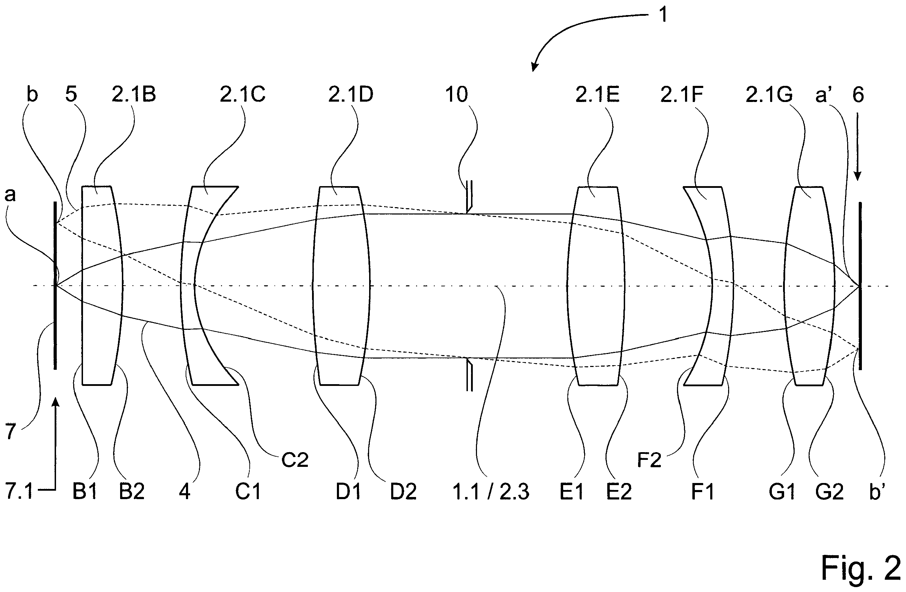

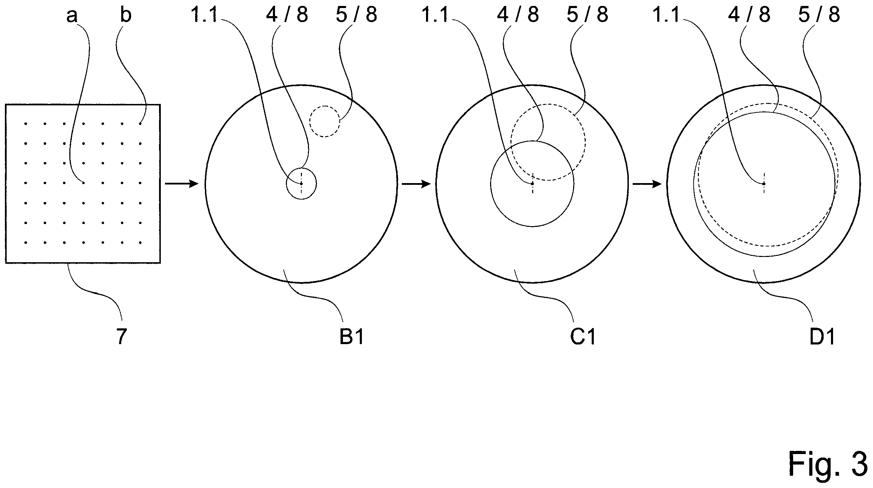

In der Fig. 1 ist vereinfachend eine Linse als ein individualisiertes optisches Element 2.1 in einer halbperspektivischen Darstellung gezeigt. Das individualisierte optische Element 2.1 weist eine ebene Umfangsfläche auf, die sich koaxial zu einer durch den Mittelpunkt des individualisierten optischen Elements 2.1 verlaufenden optischen Achse 2.3 erstreckt. Dem Betrachter ist eine Seitenfläche 2.2 des optischen individualisierten Elements 2.1 zugewandt. Auf der Umfangsfläche des individualisierten optischen Elements 2.1 ist eine Markierung 3 in Form eines Punktes vorhanden. Die Markierung 3 ist zu derjenigen Seitenfläche 2.2 versetzt angebracht, die in einer virtuellen optischen Anordnung 1 (siehe Fig. 2 und 3) in Richtung einer Objektebene 7.1 weist. Ebenfalls auf der Umfangsfläche ist eine Kennung 9 vorhanden, durch die das individualisierte optische Element 2.1 individualisiert ist, indem einem optischen Element 2 eine eindeutige Buchstaben-Ziffernfolge (hier durch "Identifier" symbolisiert) zugeordnet und auf der Kennung 9 vermerkt ist.

Ein in Fig. 2 gezeigtes erstes Ausführungsbeispiel einer virtuellen optischen Anordnung 1 weist als wesentliche Komponenten eine Anzahl individualisierter optischer Elemente 2.1B bis 2.1G sowie eine Blende 10 entlang einer optischen Achse 1.1 der virtuellen optischen Anordnung 1 sowie eine Bildebene 6 und eine Objektebene 7.1 auf, in der ein Objekt 7 angeordnet werden kann. Die optischen Achsen 2.3 der individualisierten optischen Elemente 2.1B bis 2.1 G und die optische Achse 1.1 der virtuellen optischen Anordnung 1 fallen zusammen. Das erste Ausführungsbeispiel ist stark schematisiert und vereinfacht und dient lediglich der Illustration und Erläuterung der Erfindung. Jedes individualisierte optische Element 2.1B bis 2.1G weist zwei Seitenflächen auf, wobei die der Objektebene 7.1 zugewandte Seitenfläche den Index 1 (B1, C1, ... G1) und die der Bildebene 6 zugewandte Seitenfläche den Index 2 (B2, C2, ...G2) besitzt.

Ausgehend von dem Objekt 7 sind beispielhaft aus einer beliebigen Anzahl virtueller Strahlenbündel ausgewählt, ein erstes virtuelles Strahlenbündel 4 und ein zweites virtuelles Strahlenbündel 5 gezeigt. Das erste virtuelle Strahlenbündel 4 ist einem Feldpunkt a und das zweite virtuelle Strahlenbündel 5 ist einem Feldpunkt b zugeordnet. Die Feldpunkte a und b sind in einer Matrix von Feldpunkten (siehe Fig. 3) angeordnet. Das erste virtuelle Strahlenbündel 4 geht von dem Feldpunkt a des Objekts 7 aus und breitet sich entlang der optischen Achse 1.1 in der virtuellen optischen Anordnung 1 aus. Dabei divergieren die Strahlen des ersten virtuellen Strahlenbündels 4. Die Strahlen des ersten virtuellen Strahlenbündels 4 werden durch die Wirkung der individualisierten optischen Elemente 2.1B bis 2.1D parallelisiert. Über einen Abschnitt der virtuellen optischen Anordnung 1 zwischen den optischen Elementen 2.1D und 2.1E weist das erste virtuelle Strahlenbündel 4 seinen größten Querschnitt auf. Durch Wirkung der individualisierten optischen Elemente 2.1E, 2.1F und 2.1G werden die Strahlen des ersten virtuellen Strahlenbündels 4 wieder zusammengeführt und bilden den Feldpunkt a als Feldpunkt a' in der Bildebene 6 ab. Das zweite virtuelle Strahlenbündel 5 breitet sich ausgehend von dem Feldpunkt b aus. Der Feldpunkt b ist auf der Objektebene 7.1 neben dem Durchstoßpunkt der optischen Achse 1.1 durch die Objektebene 7.1 angeordnet. Das zweite virtuelle Strahlenbündel 5 wird ebenfalls durch die individualisierten optischen Elemente 2.1B bis 2.1D aufgeweitet parallelisiert und durch die individualisierten optischen Elemente 2.1E, 2.1F und 2.1G wieder zusammengeführt, bevor es in der Bildebene 6 als Feldpunkt b' abgebildet wird. Die Seitenfläche D1 ist als eine Korrekturfläche vorgesehen. Das individualisierte optische Element 2.1D ist ein ausgewähltes optisches Element, welches zur Korrektur eines Gesamtwellenfrontfehlers aus den individualisierten optischen Elementen 2.1B bis 2.1G der optischen Anordnung 1 ausgewählt ist.

In Fig. 3 ist eine der virtuellen optischen Anordnung 1 zugewandte Fläche des Objekts 7 sowie die Seitenflächen B1, C1 und D1 der individualisierten optischen Elemente 2.1B, 2.1C und 2.1D (siehe Fig. 2) in der Draufsicht gezeigt. Auf dem Objekt 7 sind Feldpunkte in einer Matrix angeordnet dargestellt. Durch die Matrix sind die Feldpunkte in einem regelmäßigen Raster mit gleichen Rasterabständen zueinander angeordnet. Die Feldpunkte a und b sind beispielhaft bezeichnet. Das erste und das zweite virtuelle Strahlenbündel 4, 5 sind gegenüber den Feldpunkten a bzw. b aufgeweitet und auf der Seitenfläche B1 als Projektionen abgebildet. Diese Projektionen weisen eine durch den Querschnitt der virtuellen Strahlenbündel 4, 5 und durch die Gestalt der Seitenfläche B1 bestimmte Form und Größe auf und werden als Subaperturen 8 bezeichnet. Eine relative Lage jeder Subapertur 8 zur optischen Achse 1.1 ist durch die Lage der Feldpunkte in der Matrix sowie durch die Position der jeweils betrachteten Seitenfläche B1 bis G2 der optischen Elemente B bis G in der optischen Anordnung bestimmt. Die Subapertur 8 des ersten virtuellen Strahlenbündels 4 erstreckt sich symmetrisch um die optische Achse 1.1. Die Subapertur 8 des zweiten virtuellen Strahlenbündels 5 befindet sich auf der Seitenfläche B1 in einer relativen Lage zur optischen Achse 1.1, die der relativen Lage des Feldpunkts b in der Matrix entspricht.

Die auf der Seitenfläche C1 vorhandene Subapertur 8 des ersten virtuellen Strahlenbündels 4 ist wiederum symmetrisch um die optische Achse 1.1 vorhanden und gegenüber der Subapertur 8 auf der Seitenfläche B1 aufgeweitet. Die Subapertur 8 des zweiten virtuellen Strahlenbündels 5 ist ebenfalls vergrößert und überlappt teilweise mit der Subapertur 8 des ersten virtuellen Strahlenbündels 4.

Auf der Seitenfläche D1 sind die Subaperturen 8 des ersten und zweiten virtuellen Strahlenbündels 4, 5 um die optische Achse 1.1 vorhanden und überlappen sich gegenseitig nahezu vollständig. Durch die Subaperturen 8 ist zudem eine freie, d. h. nicht von einer Fassung überdeckte, Oberfläche des individualisierten optischen Elements 2.1D nahezu gänzlich ausgefüllt.

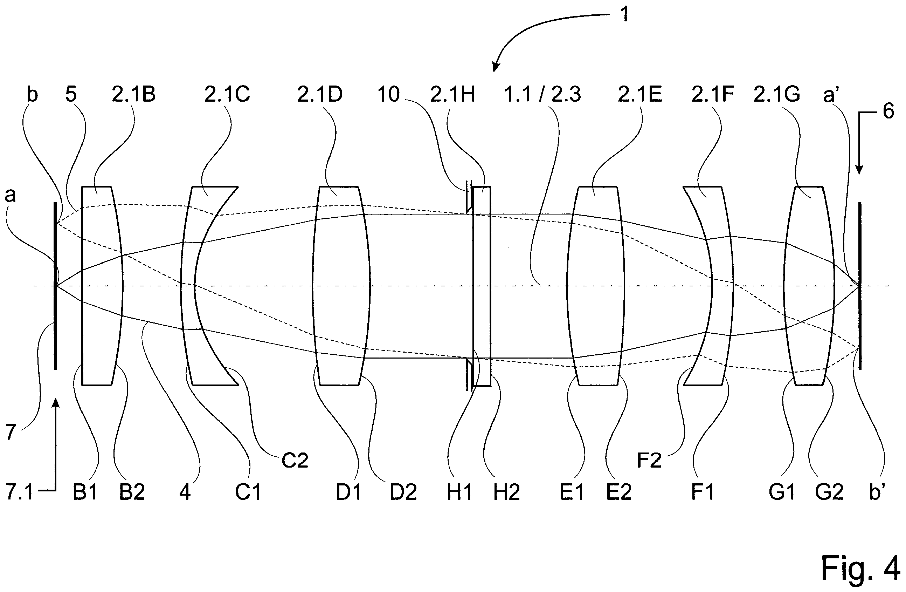

Ein zweites Ausführungsbeispiel der optischen Anordnung 1 gemäß Fig. 4 entspricht dem ersten Ausführungsbeispiel mit dem Unterschied, dass zwischen den individualisierten optischen Elementen 2.1D und 2.1E neben der Blende 10 ein individualisiertes optisches Element 2.1H aufweisend Seitenflächen H1 und H2 angeordnet ist. Zwischen den individualisierten optischen Elementen 2.1D und 2.1E verlaufen die Strahlen der virtuellen Strahlenbündel 4, 5, aber auch die Strahlen aller nicht gezeigten virtuellen Strahlenbündel, zueinander parallel. Das individualisierte optische Element 2.1H ist als eine Planplatte aus optischem Glas ausgebildet. Das individualisierte optische Element 2.1H ist in seiner optischen Wirkung neutral.

Anhand der Fig. 1 bis 3 wird das erfindungsgemäße Verfahren nachfolgend erläutert. Eine Anzahl von verschiedenen optischen Elementen 2 wird hergestellt. Jedem optischen Element 2 wird eine Kennung 9 zugeordnet, durch die das optische Element 2 individuell gekennzeichnet, d. h. individualisiert, ist (Fig. 1). Außerdem wird eine Markierung 3 am Rand des derart individualisierten optischen Elements 2.1 angebracht. Ausgehend von der Markierung 3 kann jeder Punkt auf der Oberfläche des individualisierten optischen Elements 2.1 durch ein geeignetes Koordinatensystem (kartesisches Koordinatensystem, Polarkoordinatensystem) eindeutig beschrieben werden. Jedes individualisierte optische Element 2.1 wird anschließend vermessen und Irregularitäten der Oberflächen des individualisierten optischen Elements 2.1 werden in Bezug auf ihre Lage, Form und Ausdehnung auf einer Oberfläche des individualisierten optischen Elements 2.1 sowie in Bezug auf die Qualität der jeweiligen Irregularität und die daher zu erwartenden optischen Wirkungen lage- und koordinatenrichtig erfasst und, dem individualisierten optischen Element 2.1 zugeordnet, als Messdaten in einer Datenbank (nicht gezeigt) gespeichert. Eine Lage und die Koordinaten des individualisierten optischen Elements 2.1 werden in Bezug auf die an dem individualisierten optischen Element 2.1 vorhandene Markierung 3 erfasst.

Zur virtuellen Herstellung einer virtuellen optischen Anordnung 1 werden entsprechend den zur Herstellung benötigten optischen Elementen 2 individualisierte optische Elemente 2.1B bis 2.1G aus der Datenbank ausgewählt und deren Messdaten bereitgestellt. Die individualisierten optischen Elemente 2.1B bis 2.1G werden virtuell entlang der optischen Achse 1.1 mit bekannten Ausrichtungen der Seitenflächen (Lage) und mit bekannter Drehlage angeordnet. Die Drehlage ist durch die bekannte Lage der Markierung 3 bezüglich einer definierten Bezugsposition um die optische Achse 1.1 gegeben und bekannt.

Ein Gesamtwellenfrontfehler wird ermittelt, indem virtuelle Strahlenbündel 4, 5 in einem bekannten Raster und mit bekannten Rasterabständen zueinander generiert werden. Der Verlauf dieser virtuellen Strahlenbündel 4, 5 durch die virtuelle optische Anordnung 1 wird berechnet (Fig. 3). Dabei werden neben dem Verlauf auch Konvergenzen, Divergenzen und Parallelitäten der virtuellen Strahlenbündel 4, 5 zueinander berechnet. Da von jedem in einer jeweiligen virtuellen optischen Anordnung 1 verwendeten individualisierten optischen Element 2.1 die Messdaten sowie die Lage und die Drehlage bekannt sind, ist eine koordinatenrichtige Berechnung der virtuellen Strahlenbündel 4, 5 der auf einer Seitenfläche B1 bis H2 und der jeweils an einer Subapertur 8 eines individualisierten optischen Elements 2.1B bis 2.1G auftretenden individuellen Wellenfrontfehler mittels Verfahren möglich, die dem Fachmann bekannt sind.

So werden die jeweilige Subapertur 8 und / oder die Seitenfläche(-n) jedes individualisierten optischen Elements 2.1 als Koeffizienten von Zernike-Polynomen beschrieben. Aus den individuellen Wellenfrontfehlern wird durch vorzeichenrichtige Addition ein Gesamtwellenfrontfehler der virtuellen optischen Anordnung 1 berechnet. In einer weiteren Ausführung des erfindungsgemäßen Verfahrens wird ein Nominalfehler (Restfehler des Optikdesigns; auch als nomineller Fehler bezeichnet) der virtuellen optischen Anordnung 1 ermittelt und bei der Berechnung des Gesamtwellenfrontfehlers berücksichtigt.

Die Seitenfläche D2 wird in der beschriebenen Ausführung des erfindungsgemäßen Verfahrens von Anfang an als Korrekturfläche festgelegt. Das individualisierte optische Element 2.1D ist ein Weißteil, während die anderen individualisierten optischen Elemente 2.1B, 2.1C, 2.1E, 2.1F und 2.1G bereits fertig beschichtet und gefasst sind und sich in einem Endzustand befinden. Nach der Berechnung des Gesamtwellenfrontfehlers wird dieser mit zulässigen Toleranzgrenzen verglichen. Liegt der Gesamtwellenfrontfehler außerhalb der zulässigen Toleranzgrenzen, wird lage- und koordinaterichtig berechnet, welche Veränderungen an dem ausgewählten optischen Element 2.1D, und dort auf der Korrekturfläche D2, vorzunehmen sind, um einen Gesamtwellenfrontfehler zu erhalten, der innerhalb der zulässigen Toleranzgrenzen liegt. Die erforderlichen virtuellen Veränderungen, durch die eine Einhaltung der Toleranzgrenzen erreicht wird, werden als Bearbeitungsdaten abgespeichert.

Anschließend wird das ausgewählte individualisierte optische Element 2.1D entsprechend den Bearbeitungsdaten bearbeitet und verändert. Nach der Bearbeitung wird das ausgewählte individualisierte optische Element 2.1D beschichtet und gefasst.

Die individualisierten optischen Elemente 2.1B bis 2.1G, mit denen die virtuelle optische Anordnung 1 hergestellt wurde, werden nun tatsächlich zur Herstellung einer optischen Anordnung verwendet und entlang einer optischen Achse 1.1 der tatsächlichen optischen Anordnung (nicht gezeigt) lage- und koordinatenrichtig angeordnet. Gegebenenfalls erfolgen noch Justagen der individualisierten optischen Elemente 2.1B bis 2.1G.

In einer weiteren Ausgestaltung des erfindungsgemäßen Verfahrens wird in der virtuellen optischen Anordnung 1 gemäß Fig. 4 das individualisierte optische Element 2.1H in einem Abschnitt der virtuellen optischen Anordnung 1 positioniert, über den sich die virtuellen Strahlenbündel nahezu vollständig überlappen und die freie Oberfläche dort angeordneter optischer Elemente 2.1D, 2.1E überdecken. Das individualisierte optische Element 2.1H entfaltet theoretisch keine optische Wirkung. Wenigstens eine der Seitenflächen H1, H2 ist als Korrekturfläche vorgesehen. Das individualisierte optische Element 2.1H ist das ausgewählte individualisierte optische Element, von dem ebenfalls Messdaten lage- und koordinatenrichtig erfasst und abgespeichert werden.

Nachdem der Gesamtwellenfrontfehler der virtuellen optischen Anordnung 1 berechnet wurde, werden erforderlichenfalls die vorzunehmenden Veränderungen der Korrekturfläche(-n) H1 und / oder H2 berechnet und als Bearbeitungsdaten gespeichert, durch die ein Gesamtwellenfrontfehler innerhalb zulässiger Toleranzgrenzen erreicht wird. Sind keine Veränderungen vorzunehmen, kann in einer weiteren Ausführung der Erfindung auf das Anordnen des individualisierten optischen Elements 2.1 H verzichtet werden.

In einer weiteren Ausgestaltung des erfindungsgemäßen Verfahrens ist ein Beitrag des individualisierten optischen Elements 2.1H zu dem Nominalfehler der optischen Anordnung 1 bekannt und wird berücksichtigt. In weiteren Ausgestaltungen wird neben dem individualisierten optischen Element 2.1H mindestens ein weiteres individualisiertes optisches Element 2.1 ausgewählt.

### Bezugszeichenliste

- 1: virtuelle optische Anordnung
- 1.1: optische Achse (der virtuellen optischen Anordnung 1)
- 2: optisches Element
- 2.1: individualisiertes optisches Element
- 2.2: Seitenfläche (eines individualisierten optischen Elements 2.1)
- 2.3: optische Achse (eines individualisierten optischen Elements 2.1)
- 3: Markierung
- 4: erstes virtuelles Strahlenbündel
- 5: zweites virtuelles Strahlenbündel
- 6: Bildebene
- 7: Objekt
- 7.1: Objektebene
- 8: Subapertur
- 9: Kennung
- 10: Blende
- a: Feldpunkt (auf dem Objekt 7)
- b: Feldpunkt (auf dem Objekt 7)
- a': Feldpunkt (in der Bildebene 6)
- b': Feldpunkt (in der Bildebene 6)

## Patentansprüche

1. Verfahren zur Herstellung einer wellenfrontkorrigierten optischen Anordnung aus mindestens zwei optischen Elementen (2), bei dem
in einem Schritt a) ein Gesamtwellenfrontfehler der optischen Anordnung ermittelt wird,
in einem Schritt b) der Gesamtwellenfrontfehler mit einem zulässigen Toleranzbereich des Gesamtwellenfrontfehlers verglichen wird,
in einem Schritt c) bei einer Überschreitung des zulässigen Toleranzbereiches mindestens eines der optischen Elemente (2) ausgewählt wird und
in einem Schritt d) die optischen Eigenschaften des mindestens einen ausgewählten optischen Elements (2) derart verändert werden, dass der ermittelte Gesamtwellenfrontfehler der optischen Anordnung innerhalb des zulässigen Toleranzbereiches zu liegen kommt,
**dadurch gekennzeichnet, dass**
- vor dem Schritt a):
- in einem Schritt a-2) die optischen Elemente (2) individualisiert werden, indem diesen jeweils eine individuelle Kennung (9) zugeordnet wird, sodass individualisierte optische Elemente (2.1B bis 2.1H) vorliegen, von allen individualisierten optischen Elementen (2.1B bis 2.1H) individuelle Oberflächenfehler koordinatenrichtig gemessen werden und die gemessenen individuellen Oberflächenfehler koordinatenrichtig dem jeweiligen individualisierten optischen Element (2.1B bis 2.1H) zugeordnet gespeichert werden und
- in einem Schritt a-1) die optische Anordnung mit den individualisierten optischen Elemente (2.1B bis 2.1H) virtuell als eine virtuelle optische Anordnung (1) hergestellt wird,
- in dem Schritt a) das Ermitteln des Gesamtwellenfrontfehlers der virtuellen optischen Anordnung (1) durch Berechnung aus den individuellen Oberflächenfehlern erfolgt und ein berechneter Gesamtwellenfrontfehler erhalten wird, wobei der Gesamtwellenfrontfehler die Gesamtheit von Wellenfrontfehlern über alle Feldpunkte ist, sodass eine Korrektur des Gesamtwellenfrontfehlers gleichzeitig für alle Feldpunkte ermöglicht ist;
- in dem Schritt b) der berechnete Gesamtwellenfrontfehler mit dem zulässigen Toleranzbereich des Gesamtwellenfrontfehlers verglichen wird,
- in dem Schritt d) die optischen Eigenschaften des mindestens einen ausgewählten individualisierten optischen Elements (2.1B bis 2.1H) virtuell so verändert werden, dass der berechnete Gesamtwellenfrontfehler der virtuellen optischen Anordnung (1) innerhalb des zulässigen Toleranzbereiches zu liegen kommt,
- in einem Schritt e) die virtuell vorgenommenen Veränderungen der optischen Eigenschaften des mindestens einen ausgewählten individualisierten optischen Elements (2.1B bis 2.1H) als Bearbeitungsdaten gespeichert und wiederholt abrufbar bereitgestellt werden und
- in einem Schritt f) das mindestens eine ausgewählte individualisierte optische Element (2.1B bis 2.1H) entsprechend der Bearbeitungsdaten bearbeitet wird und die optische Anordnung mit den individualisierten optischen Elementen (2.1B bis 2.1H) hergestellt wird.

2. Verfahren nach Anspruch 1, **dadurch gekennzeichnet, dass**
in Schritt a) eine beliebige Anzahl von Feldpunkten (a, b) betrachtet und für jeden Feldpunkt (a, b) virtuelle Strahlenbündel (4, 5) erzeugt und deren Projektion auf jede Oberfläche jedes individualisierten optischen Elements (2.1B bis 2.1H) beim Durchgang durch die virtuelle optische Anordnung (1) als eine Subapertur (8) berechnet wird.

3. Verfahren nach Anspruch 2 **dadurch gekennzeichnet, dass**
von jedem Feldpunkt (a, b) aus den individuellen Oberflächenfehlern der Subapertur (8) ein jeweiliger Wellenfrontfehleranteil berechnet und gespeichert wird.

4. Verfahren nach Anspruch 3, **dadurch gekennzeichnet, dass**
von jeder Subapertur (8) ein Beitrag zum berechneten Gesamtwellenfrontfehler abgeleitet wird.

5. Verfahren nach Anspruch 4, **dadurch gekennzeichnet, dass**
die abgeleiteten Beiträge zum berechneten Gesamtwellenfrontfehler vorzeichenrichtig und orientierungsrichtig addiert werden.

6. Verfahren nach Anspruch 4, **dadurch gekennzeichnet, dass**
die abgeleiteten Beiträge zum berechneten Gesamtwellenfrontfehler in Koeffizienten zerlegt und anschließend die Koeffizienten vorzeichenrichtig und orientierungsrichtig addiert werden.

7. Verfahren nach einem der Ansprüche 1 bis 6, **dadurch gekennzeichnet, dass**
die virtuellen Strahlenbündel (4, 5) in einem beliebigen Raster mit bekannten Rasterabständen zueinander angeordnet werden.

8. Verfahren nach Anspruch 7, **dadurch gekennzeichnet, dass**
die Rasterabstände so gewählt werden, dass sich die Subaperturen (8) auf der Oberfläche mindestens eines ausgewählten individualisierten optischen Elements (2.1B bis 2.1H) überlagern.

9. Verfahren nach einem der Ansprüche 1 bis 8, **dadurch gekennzeichnet, dass**
für jeden Feldpunkt (a, b) ein Beitrag zum berechneten Gesamtwellenfrontfehler berücksichtigt wird, der als ein Nominalfehler einer als ideal angenommenen virtuellen optischen Anordnung (1) bekannt ist.

10. Verfahren nach einem der Ansprüche 1 bis 9, **dadurch gekennzeichnet, dass** zusätzlich eine Verzeichnung in einer Bildebene (6) auf einem feldnahen individualisierten optischen Element (2.1B bis 2.1H korrigiert wird.

11. Verfahren nach einem der Ansprüche 1 bis 10, **dadurch gekennzeichnet, dass** die individualisierten optischen Elemente (2.1) nicht beschichtet sind.

12. Verfahren nach einem der Ansprüche 1 bis 10, **dadurch gekennzeichnet, dass** das mindestens eine ausgewählte individualisierte optische Element (2.1B bis 2.1H) nicht beschichtet ist.

13. Verfahren nach einem der Ansprüche 11 oder 12, **dadurch gekennzeichnet, dass** in Schritt f) vor der Herstellung der optischen Anordnung alle nicht beschichteten individualisierten optischen Elemente (2.1) in einen Endzustand überführt werden.

14. Verfahren nach einem der vorhergehenden Ansprüche, **dadurch gekennzeichnet, dass**
die Anzahl der in Schritt **c)** ausgewählten individualisierten optischen Elemente (2.1B bis 2.1H) in Abhängigkeit von dem virtuell ermittelten Gesamtwellenfrontfehler erfolgt.

15. Verwendung des Verfahrens nach einem der Ansprüche 1 bis 14, um anhand der Messdaten aus einer Anzahl von individualisierten optischen Elementen (2.1B bis 2.1H) Kombinationen der individualisierten optischen Elemente (2.1B bis 2.1H) auszuwählen und die Auswahl der Kombinationen so erfolgt, dass die für eine Kombination berechneten Bearbeitungsdaten fertigungstechnisch optimiert sind.

## Claims

1. Method for producing a wavefront-corrected optical arrangement consisting of at least two optical elements (2), in which
in a step a), a total wavefront error of the optical arrangement is determined,
in a step b), the total wavefront error is compared with a permissible tolerance range of the total wavefront error,
in a step c), at least one of the optical elements (2) is selected if the permissible tolerance range is exceeded, and
in a step d), the optical properties of the at least one selected optical element (2) are changed such that the determined total wavefront error of the optical arrangement is within the permissible tolerance range,
**characterized in that**
- before step a):
- in a step a-2), the optical elements (2) are individualized by each being assigned an individual identifier (9) such that individualized optical elements (2.1B to 2.1H) are present and, from all the individualized optical elements (2.1B to 2.1H), individual surface errors are measured with the correct coordinates and the measured individual surface errors are stored with the correct coordinates so as to be assigned to the particular individualized optical element (2.1B to 2.1H), and
- in a step a-1), the optical arrangement comprising the individualized optical elements (2.1B to 2.1H) is produced virtually as a virtual optical arrangement (1),
- in step a), the total wavefront error of the virtual optical arrangement (1) is determined by means of a calculation from the individual surface errors, and a calculated total wavefront error is obtained, the total wavefront error being the totality of wavefront errors over all field points, such that it is possible to correct the total wavefront error simultaneously for all field points;
- in step b), the calculated total wavefront error is compared with the permissible tolerance range of the total wavefront error,
- in step d), the optical properties of the at least one selected individualized optical element (2.1B to 2.1H) are virtually changed such that the calculated total wavefront error of the virtual optical arrangement (1) is within the permissible tolerance range,
- in a step e), the changes made virtually to the optical properties of the at least one selected individualized optical element (2.1B to 2.1H) are stored as processing data and made available such that they can be retrieved repeatedly, and
- in a step f), the at least one selected individualized optical element (2.1B to 2.1H) is processed according to the processing data and the optical arrangement comprising the individualized optical elements (2.1B to 2.1H) is produced.

2. Method according to claim 1, **characterized in that** in step a), an arbitrary number of field points (a, b) is considered and virtual beams (4, 5) are generated for each field point (a, b), and the projection of said beams onto each surface of each individualized optical element (2.1B to 2.1H) while passing through the virtual optical arrangement (1) is calculated as a subaperture (8).

3. Method according to claim 2, **characterized in that** from each field point (a, b), a corresponding wavefront error component is calculated from the individual surface errors of the subaperture (8) and stored.

4. Method according to claim 3, **characterized in that**
a contribution to the calculated total wavefront error is derived from each subaperture (8).

5. Method according to claim 4, **characterized in that**
the derived contributions to the calculated total wavefront error are added up with the correct sign and correct orientation.

6. Method according to claim 4, **characterized in that**
the derived contributions to the calculated total wavefront error are broken down into coefficients and the coefficients are then added up with the correct sign and correct orientation.

7. Method according to any of claims 1 to 6, **characterized in that**
the virtual beams (4, 5) are arranged in an arbitrary grid with known grid spacings with respect to one another.

8. Method according to claim 7, **characterized in that**
the grid spacings are selected such that the subapertures (8) overlap on the surface of at least one selected individualized optical element (2.1B to 2.1H).

9. Method according to any of claims 1 to 8, **characterized in that**
a contribution to the calculated total wavefront error, known as a nominal error of a virtual optical arrangement (1) assumed to be ideal, is taken into account for each field point (a, b).

10. Method according to any of claims 1 to 9, **characterized in that** a distortion in an image plane (6) on a near-field individualized optical element (2.1B to 2.1H) is corrected in addition.

11. Method according to any of claims 1 to 10, **characterized in that** the individualized optical elements (2.1) are not coated.

12. Method according to any of claims 1 to 10, **characterized in that** the at least one selected individualized optical element (2.1B to 2.1H) is not coated.

13. Method according to either claim 11 or claim 12, **characterized in that**, in step f), all uncoated individualized optical elements (2.1) are converted into a final state prior to the production of the optical arrangement.

14. Method according to any of the preceding claims, **characterized in that** the number of individualized optical elements (2.1B to 2.1H) selected in step c) is based on the virtually determined total wavefront error.

15. Use of the method according to any of claims 1 to 14 for selecting, on the basis of measurement data, combinations of individualized optical elements (2.1B to 2.1H) from a number of individualized optical elements (2.1B to 2.1H), and the combinations are selected such that the processing data calculated for a combination are optimized for manufacturing.

## Revendications

1. Procédé de fabrication d'un système optique à front d'onde corrigé composé d'au moins deux éléments optiques (2), dans lequel,
à une étape a), on détermine une anomalie de front d'onde globale du système optique,
à une étape b), l'anomalie de front d'onde globale est comparée à une plage de tolérance autorisée de l'anomalie de front d'onde globale,
à une étape c), au moins l'un des éléments optiques (2) est sélectionné lorsque la plage de tolérance autorisée est dépassée, et
à une étape d), les propriétés optiques de l'au moins un élément optique sélectionné (2) sont modifiées de sorte que l'anomalie de front d'onde globale déterminée du système optique se trouve dans la plage de tolérance autorisée,
**caractérisé en ce que**
- avant l'étape a) :
- à une étape a-2), les éléments optiques (2) sont individualisés par l'affectation à chacun d'eux d'un identifiant individuel (9), afin d'obtenir des éléments optiques individualisés (2.1B à 2.1H), des anomalies de surface individuelles sont mesurées en respectant les coordonnées pour tous les éléments optiques individualisés (2.1B à 2.1H), et les anomalies de surface individuelles mesurées sont mémorisées en respectant les coordonnées et en les faisant correspondre à l'élément optique individualisé (2.1B à 2.1H) respectif, et
- à une étape a-1), le système optique comportant les éléments optiques individualisés (2.1B à 2.1H) est fabriqué virtuellement sous la forme d'un système optique virtuel (1),
- à l'étape a), l'anomalie de front d'onde globale du système optique virtuel (1) est déterminée par calcul à partir des anomalies de surface individuelles, ce qui permet d'obtenir une anomalie de front d'onde globale calculée, l'anomalie de front d'onde globale étant la totalité des anomalies de front d'onde sur tous les points de champ, de sorte qu'une correction de l'anomalie de front d'onde globale est rendue possible simultanément pour tous les points de champ ;
- à l'étape b), l'anomalie de front d'onde globale calculée est comparée à la plage de tolérance autorisée de l'anomalie de front d'onde globale,
- à l'étape d), les propriétés optiques de l'au moins un élément optique individualisé (2.1B à 2.1H) sélectionné sont modifiées virtuellement de sorte que l'anomalie de front d'onde globale calculée du système optique virtuel (1) se trouve dans la plage de tolérance autorisée,
- à une étape e), les modifications effectuées virtuellement dans les propriétés optiques de l'au moins un élément optique individualisé (2.1B à 2.1H) sélectionné sont mémorisées sous forme de données de traitement et mises à disposition pour être régulièrement consultées, et
- à une étape f), l'au moins un élément optique individualisé (2.1B à 2.1H) sélectionné est traité en fonction des données de traitement et le système optique est fabriqué à l'aide des éléments optiques individualisés (2.1B à 2.1H).

2. Procédé selon la revendication 1, **caractérisé en ce que**,
à l'étape a), un nombre quelconque de points de champ (a, b) est pris en compte, et des faisceaux virtuels (4, 5) sont produits pour chaque point de champ (a, b), et leur projection sur chaque surface de chaque élément optique individualisé (2.1B à 2.1H) est calculée comme une sous-ouverture (8) lors de son passage à travers le réseau optique virtuel (1).

3. Procédé selon la revendication 2, **caractérisé en ce que**,
pour chaque point de champ (a, b), une proportion d'anomalie de front d'onde respective est calculée à partir des anomalies de surface individuelles de la sous-ouverture (8), et mémorisée.

4. Procédé selon la revendication 3, **caractérisé en ce**
**qu'**une contribution à l'anomalie de front d'onde globale calculée est dérivée de chaque sous-ouverture (8).

5. Procédé selon la revendication 4, **caractérisé en ce que**
les contributions dérivées, à l'anomalie de front d'onde globale calculée, sont additionnées en respectant le signe et l'orientation.

6. Procédé selon la revendication 4, **caractérisé en ce que**
les contributions dérivées, à l'anomalie de front d'onde globale calculée, sont décomposées en coefficients, et les coefficients sont ensuite additionnés en respectant le signe et l'orientation.

7. Procédé selon l'une des revendications 1 à 6, **caractérisé en ce que** les faisceaux virtuels (4, 5) sont disposés les uns par rapport aux autres dans une grille quelconque comportant des espacements connus.

8. Procédé selon la revendication 7, **caractérisé en ce que**
les espacements sont sélectionnés de telle manière que les sous-ouvertures(8) se chevauchent sur la surface d'au moins un élément optique individualisé (2.1B à 2.1H) sélectionné.

9. Procédé selon l'une des revendications 1 à 8, **caractérisé en ce que**,
pour chaque point de champ (a, b), on tient compte d'une contribution à l'anomalie de front d'onde globale calculée, appelée anomalie nominale d'un système optique virtuel (1) supposé idéal.

10. Procédé selon l'une des revendications 1 à 9, **caractérisé en ce que**, en outre, une distorsion dans un plan d'image (6) sur un élément optique individualisé (2.1B à 2.1H) de champ proche est corrigée.

11. Procédé selon l'une des revendications 1 à 10, **caractérisé en ce que** les éléments optiques individualisés (2.1) ne sont pas revêtus.

12. Procédé selon l'une des revendications 1 à 10, **caractérisé en ce que** l'au moins un élément optique individualisé (2.1B à 2.1H) sélectionné n'est pas revêtu.

13. Procédé selon l'une des revendications 11 ou 12, **caractérisé en ce que**, à l'étape f), avant la fabrication du système optique, tous les éléments optiques individualisés (2.1) non revêtus sont transférés dans un état final.

14. Procédé selon l'une des revendications précédentes, **caractérisé en ce que** le nombre d'éléments optiques individualisés (2.1B à 2.1H) sélectionnés à l'étape c) est fonction de l'anomalie de front d'onde globale déterminée virtuellement.

15. Utilisation du procédé selon l'une des revendications 1 à 14 pour sélectionner des combinaisons des éléments optiques individualisés (2.1B à 2.1H) sur la base des données de mesure d'un certain nombre d'éléments optiques individualisés (2.1B à 2.1H), et la sélection des combinaisons a lieu de telle manière que les données de traitement calculées pour une combinaison soient optimisées en termes de technique de fabrication.
